# EUROPÄISCHE PATENTSCHRIFT

(11) **EP 3 715 497 B1**
(45) Veröffentlichungstag und Bekanntmachung des Hinweises auf die Patenterteilung: **06.05.2026**
(21) Anmeldenummer: 19166395.4
(22) Anmeldetag: 29.03.2019
(51) Int. Cl.: C23C 14/08, C23C 14/34, H01J 37/34

(54) **SPUTTERINGTARGET ZUR HERSTELLUNG MOLYBDÄNOXIDHALTIGER SCHICHTEN**
SPUTTERING TARGET FOR PRODUCING LAYERS CONTAINING MOLYBDENUM OXIDE
CIBLE DE PULVÉRISATION DESTINÉE À LA FABRICATION DE COUCHES CONTENANT DE L'OXYDE DE MOLYBDÈNE

(43) Veröffentlichungstag der Anmeldung: 30.09.2020
(73) Patentinhaber: Plansee SE, 6600 Reutte (AT)
(72) Erfinder: O`SULLIVAN, Michael, 6600 Reutte (AT); LINKE, Christian, 6600 Reutte (AT); FRANZKE, Enrico, 6600 Reutte (AT); KÖSTENBAUER, Harald, 6600 Reutte (AT); WINKLER, Jörg, 6600 Reutte (AT)
(74) Vertreter: Ciesla, Bettina

(56) Entgegenhaltungen:
- WO-A1-2014/063954
- DE-A1- 102012 112 739
- DE-A1- 102014 111 935
- PACHLHOFER JULIA M ET AL: "Non-reactive dc magnetron sputter deposition of Mo-O thin films from ceramic MoOxtargets", SURFACE AND COATINGS TECHNOLOGY, vol. 332, 18 September 2017 (2017-09-18), pages 80 - 85, XP085293368, ISSN: 0257-8972, DOI: 10.1016/J.SURFCOAT.2017.07.083

## Beschreibung

Die vorliegende Erfindung betrifft ein Sputteringtarget zur Herstellung molybdänoxidhaltiger Schichten, die Verwendung solch eines Sputteringtargets zur Gasphasen-Abscheidung einer molybdänoxidhaltigen Schicht.

Targetmaterialien aus Molybdänoxid (MoOₓ) werden in Kathodenzerstäubungsanlagen wie PVD-Beschichtungsanlagen (PVD engl. physical vapour deposition) verwendet, um molybdänoxidhaltige Schichten in einem Vakuumprozess aus der Gasphase abzuscheiden. Bei diesem Beschichtungsprozess (Sputterprozess) werden die schichtbildenden Teilchen aus dem (Sputter-)Target in die Gasphase übergeführt und durch Kondensation dieser Teilchen - gegebenenfalls unter Zufuhr von Sauerstoff als Reaktivgas ("reaktives Sputtern") - bildet sich auf dem zu beschichtenden Substrat eine entsprechende molybdänoxidhaltige Schicht aus.

Molybdänoxidhaltige Schichten (insbesondere auf Basis von Molybdänoxid) haben interessante optische Eigenschaften und finden deshalb insbesondere Anwendung bei Schichtstrukturen in optischen bzw. optoelektronischen Applikationen wie beispielsweise elektronischen Displays. Ihre Anwendung erfolgt häufig in Kombination mit bzw. direkt angrenzend zu metallischen Schichten aus z.B. Aluminium (Al), Kupfer (Cu), Titan (Ti), oder (metallischem) Molybdän (Mo), die z.B. als elektrische Leiterbahnen fungieren. Ein Anwendungsbeispiel von Molybdänoxidschichten ist JP 2013020347 A zu entnehmen, in der metallische Leiterbahnen innerhalb des Displays eines kapazitiven Berührungssensors (Engl.: touch screen) durch eine lichtabsorbierende Schicht aus MoOx abgedeckt werden, um unerwünschte Reflexionen der metallischen Leiterbahnen zu unterdrücken.

Wichtige Eigenschaften wie Lichtabsorptions-, Lichtreflexions-, Lichttransmissionsgrad, Ätzrate (relevant bei anschließender Strukturierung der abgeschiedenen Schichten mittels Fotolithographie in Verbindung mit einem nasschemischen Ätzprozess), thermische Stabilität sowie Stabilität gegenüber weiteren im Fertigungsprozess eingesetzten Chemikalien (beispielsweise Stabilität gegenüber Fotolack-Entwickler bzw.-Entferner) hängen von der genauen stöchiometrischen Zusammensetzung x der abgeschiedenen MoOₓ-Schicht bzw. den zugefügten Dotierungselementen ab. In vielen Anwendungen wie beispielsweise bei dem oben genannten kapazitiven Berührungssensor werden MoOₓ-Schichten gefordert, in denen das Molybdänoxid in einer substöchiometrischen Zusammensetzung vorliegt, d.h. das Oxid hat unbesetzte Sauerstoff-Valenzen und es liegen in der abgeschiedenen MoOₓ-Schicht Sauerstofffehlstellen vor. Insbesondere substöchiometrische MoOₓ-Schichten mit einem x-Bereich von MoO_{2.5} bis MoO_{2.98} waren bislang aufgrund ihrer elektro-optischen Eigenschaften für derartige Anwendungen von besonderem Interesse. Sie absorbieren Licht im sichtbaren Wellenlängenbereich und sind gleichzeitig noch ausreichend elektrisch leitfähig (Flächenwiderstand < 20 kΩ/ Square bzw. <20kΩ/Square), in der Regel sind sie halbleitend.

Die einfachste Möglichkeit zur Herstellung solcher substöchiometrischen MoOₓ Schichten basiert auf einem metallischen Molybdäntarget, das in einer entsprechend eingestellten Argon- und Sauerstoff-Gasatmosphäre reaktiv gesputtert wird, sodass neben Molybdän auch Sauerstoffatome in die abgeschiedene Schicht eingelagert werden. Um Schichten mit homogenen Eigenschaften, insbesondere hinsichtlich Schichtdicke und Stöchiometrie, insbesondere des Sauerstoffgehalts, zu erzielen, ist beim reaktiven Sputtern in der Umgebung des Substrats eine Atmosphäre mit präziser, zeitlich und räumlich gleichmäßiger Sauerstoffkonzentration bereitzustellen. Dies ist nur mit Hilfe sehr aufwändiger und teurer Prozesstechnik realisierbar und daher mit entsprechend hohen Kosten verbunden. Zudem treten beim reaktiven Sputtern bei Änderung des Sauerstoffpartialdrucks (z.B. beim Anlaufen der Anlage) für die Prozessstabilität nachteilige Hysterese-Effekte auf.

Neben metallischen Targets sind oxidkeramische Targetmaterialien wie MoO₂ Targets (US 2006/0165572 A1) oder Targetmaterialien mit substöchiometrischer Zusammensetzung (DE10 2012 112 739 und EP 0 852 266 A1) bekannt. US 2006/0165572 A1 offenbart ein Targetmaterial mit mindestens 99 Gew.% MoO₂. Dieses Targetmaterial beinhaltet allerdings zu wenig Sauerstoff, um damit ohne zusätzlichen Sauerstoff als Reaktivgas MoOₓ Schichten mit x > 2 abscheiden zu können.

DE10 2012 112 739 offenbart ein MoOₓ Targetmaterial mit substöchiometrischer Zusammensetzung, wobei die Zusammensetzung des Targetmaterials der Stöchiometrie in der abzuscheidenden Schicht angenähert ist. Für die Feinanpassung der Schichtstöchiometrie ist aber weiterhin eine, wenn auch im Vergleich zum Metalltarget oder MoO₂ Target geringere, Zufuhr von Sauerstoff erforderlich, was sich wie bereits oben erwähnt nachteilig auf die Qualität der abgeschiedenen Schichten auswirken kann. Nähere Angaben zur Mikrostruktur des verwendeten MoOₓ Targetmaterials fehlen. Äußerst nachteilig sind zudem die erzielbaren relativen Dichten des Targetmaterials. Für das Ausführungsbeispiel eines substöchiometrischen Oxids Nb-Mo-Oₓ wird eine relative Dichte von 85% angegeben. Seitens der Betreiber von Beschichtungsanlagen werden aber Targetmaterialien mit möglichst hoher relativer Dichte, insbesondere >95%, nachgefragt, um beim Beschichtungsprozess das Risiko von Blitzentladungen (engl.: arcs), welche unerwünschte Partikelbildung in der abgeschiedenen Schicht bewirken können, zu verringern.

Ebenso werden andere, mit Metallen dotierte Targetmaterialien mit substöchiometrischer Zusammensetzung, umfassend MoO2 und weitere substöchiometrische Verbindungen in der DE 10 2014 111 935 A1 offenbart.

Wie bereits erwähnt, werden molybdänoxidhaltige Schichten (insbesondere auf Basis von Molybdänoxid) industriell in einem Beschichtungsprozess mittels Kathodenzerstäubung ("Sputtern") hergestellt. Grundsätzlich ist es zwar möglich, solche molybdänoxidhaltigen Schichten durch reaktives Sputtern eines metallischen Targetmaterials, dass z.B. in einer entsprechend eingestellten Argon- und Sauerstoff-Prozessgasatmosphäre reaktiv gesputtert wird, herzustellen. Die Metallatome des Targetmaterials reagieren dabei zu einem hohen Anteil erst während des Beschichtungsprozesses mit dem Sauerstoff aus dem Prozessgas, so dass die Prozessführung durch Hystereseeffekte (diskontinuierliche Änderungen der Schichtabscheiderate, des Entladungsstromes und/oder der Targetspannung aufgrund von Änderungen des Sauerstoffpartialdruckes) und Vergiftung der Targetoberfläche (englisch: target poisoning) erschwert wird. Demgegenüber ist die Abscheidung von einem Sputteringtarget mit oxidischem Targetmaterial unter industriellen Bedingungen vorteilhaft, da der Beschichtungsprozess entweder mit einem reinen Edelgas-Prozessgas (in der Regel Argon) oder mit Edelgas (in der Regel Argon) als Hauptbestandteil, dem geringe Mengen weiterer Gase, wie z.B. Sauerstoff, zugesetzt sind, durchgeführt werden kann. Insbesondere werden beim Einsatz oxidischen Targetmaterials höhere Beschichtungsraten und eine höhere Prozessstabilität unter gleichzeitiger Vereinfachung der Prozessführung ermöglicht. Des Weiteren sind viele bereits installierte Beschichtungsanlagen lediglich für das Abscheiden von metallischen Schichten von einem metallischen Sputtertarget ausgelegt und erlauben deshalb nicht die Zudosierung von Sauerstoff in das Sputtergas. Die Vielseitigkeit solcher Sputteranlagen kann durch den Einsatz eines oxidischen Targetmaterials erhöht werden.

Dementsprechend besteht die Aufgabe der vorliegenden Erfindung darin, molybdänoxidhaltige Sputteringtargets bereitzustellen, bei denen ein stabiler Sputterprozess zur Herstellung qualitativ hochwertiger Schichten einstellbar ist, wobei die Sputteringtargets kostengünstig und prozesssicher in industriellem Maßstab herstellbar sein sollen, eine höhere Biegebruchfestigkeit, Wärme- und Temperaturleitfähigkeit aufweisen, daher mit höherer Leistung gesputtert werden können und deshalb höhere Abscheideraten erlauben und somit einen kostengünstigeren Prozess ermöglichen und wobei die bei Verwendung des Targets abgeschiedenen Schichten verbesserte Eigenschaften hinsichtlich der Ätzeigenschaften zeigen und gleichzeitig akzeptable Werte der Reflexion und elektrischen Leitfähigkeit zeigen.

Die Aufgabe wird gelöst durch ein Sputteringtarget gemäß Anspruch 1, durch eine Verwendung eines Sputteringtargets gemäß Anspruch 7. Vorteilhafte Weiterbildungen der Erfindung sind in den abhängigen Ansprüchen angegeben, die frei untereinander kombiniert werden können.

Gemäß der vorliegenden Erfindung wird ein Sputteringtarget mit einem elektrisch leitfähigen, oxidischen Molybdän-basiertem Targetmaterial bereitgestellt. Das Targetmaterial enthält dabei eine MoO₂-Phase sowie mindestens eine substöchiometrische Metalloxidphase, bei der mindestens ein Metall Molybdän ist, wobei im Targetmaterial das atomare Verhältnis von Sauerstoff zu Molybdän in einem Bereich von 2,1 bis 2,5 liegt, mit der Maßgabe, dass der Gesamtsauerstoffgehalt des Targetmaterials unter 71 At.% liegt.

Es wurde überraschenderweise gefunden, dass wenn das atomare Verhältnis von O zu Molybdän im Targetmaterial in einem Bereich von 2,1 bis 2,5 liegt, gegenüber den bislang im Fokus stehenden höheren Werten von über 2,5 bis 2,9, relativ niedrige Reflexionswerte von unter Verwendung des Targets gesputterter Schichten bei gleichzeitiger Erhöhung der elektrischen Leitfähigkeit der Schichten erreicht werden. Außerdem weist das Targetmaterial eine deutlich bessere Wärmeleitfähigkeit sowie eine deutlich bessere Biegefestigkeit auf gegenüber vergleichbaren Targetmaterialien mit höherem Sauerstoffgehalt.

Das "Sputtern", auch Kathodenzerstäubung genannt, ist ein physikalischer Vorgang, bei dem Atome oder Moleküle aus einem Festkörper (Targetmaterial) durch Beschuss mit energiereichen Ionen (z.B. Edelgasionen des Prozessgases) herausgelöst werden und in die Gasphase übergehen. Zur Herstellung dünner Schichten wird das zerstäubte Targetmaterial auf einem Substrat abgeschieden und bildet dort eine feste Schicht aus. Dieser zum Teil auch als Sputterdeposition bezeichnete Beschichtungsvorgang zählt zu den PVD-Verfahren (PVD: physical vapour deposition; physikalische Gasphasenabscheidung) und wird nachfolgend ebenfalls als "Sputtern" bezeichnet. Als Targetmaterial wird dasjenige als Festkörper vorliegende Material eines Sputteringtargets bezeichnet, welches für die Zerstäubung während des Sputterprozesses und für die Schichtbildung (ggf. gemeinsam mit weiteren Materialien aus dem Prozessgas und/oder von weiteren Sputteringtargets) vorgesehen ist. Das Sputteringtarget kann ausschließlich durch das Targetmaterial gebildet werden, also aus demselben bestehen, oder darüber hinaus auch noch weitere, mit dem Targetmaterial direkt oder mittelbar (d.h. über mindestens ein weiteres Bauteil) verbundene Bauteile aufweisen, wie z.B. Rückplatte(n), Trägerrohr(e), Anschlussstück(e), Einsätz(e). Das Sputteringtarget (und entsprechend das Targetmaterial) kann dabei in unterschiedlichen Geometrien bereitgestellt werden, insbesondere als planares Sputteringtarget mit unterschiedlichen Grundformen, wie z.B. quadratisch, rechteckig, rund, etc., oder auch als rohrförmiges Sputteringtarget. Das Targetmaterial bildet insbesondere einen makroskopischen Festkörper mit einer Ausdehnung entlang mindestens einer Raumrichtung von mindestens 0,03 m (Meter).

Unter einem "oxidischen" Targetmaterial wird verstanden, dass die in dem Targetmaterial enthaltenen Metalle im Wesentlichen vollständig als Oxide vorliegen. Insbesondere ist in dem Targetmaterial der Anteil an metallischen Phasen bezogen auf ein Schliffbild desselben < 1 Vol.%. Insbesondere ist der Anteil an metallischen Phasen in dem Targetmaterial unterhalb der Nachweisgrenze mittels der hier angewandten und nachstehend noch näher beschriebenen Raman-Messungen. Als "elektrisch leitfähig" wird das Targetmaterial dann bezeichnet, wenn es eine elektrische Leitfähigkeit von mindestens 80 S/m aufweist, gemessen über einen Widerstands-Messstand (Ulvac ZEM3) mit der 4-Punkt-Messmethode. Als "Phase" des Targetmaterials wird ein räumlicher Bereich desselben verstanden, innerhalb dessen eine einheitliche chemische Zusammensetzung und eine einheitliche Kristallstruktur gegeben ist, wobei die Ausrichtung der einzelnen Kristallkörner innerhalb einer Phase unterschiedlich sein kann. Als "Mischoxid" wird ein Oxid mit einer Kristallstruktur verstanden, bei dem sich das Kristallgitter aus Sauerstoffionen sowie Kationen mehrerer Elemente (vorliegend insbesondere von Mo und gegebenenfalls ein Dotierungselement Me) zusammensetzt.

Die Bestimmung der verschiedenen Phasen und deren Volumenanteile sowie auch der Dichte des Targetmaterials erfolgen anhand eines repräsentativen Querschnitts einer Probe, wobei - da ein isotropes Gefüge angenommen werden kann - die Volumenangaben aus an der Schnittfläche gemessenen Flächenanteilen abgeleitet werden (d.h. die Volumenanteile entsprechen den gemessenen Flächenanteilen). Mittels Trockenpräparation wird hierzu ein metallographischer Schliff der Probe hergestellt, wobei zur ortsaufgelösten Bestimmung der verschiedenen Metalloxid-Phasen die Raman-Spektroskopie unter Einsatz eines Raman-Mikroskops angewendet wird. Wie nachstehend noch im Detail beschrieben ist, wird bei der Raman-Spektroskopie die zu analysierende Probenoberfläche des Targetmaterials punktweise mit einem Laserstrahl abgerastert und für jeden Messpunkt ein vollständiges Raman-Spektrum erstellt ("Raman-Mapping"). Durch Vergleich des erhaltenen Raman-Spektrums für jeden Messpunkt mit Referenzspektren von verschiedenen, in Frage kommenden Metalloxiden, wird jedem Messpunkt eine entsprechende Phase zugeordnet und so eine zweidimensionale Darstellung der Phasenzusammensetzung der Probe erstellt, aus der sich dann die Flächenanteile (bzw. die Volumenanteile) der verschiedenen Phasen berechnen lassen. Die Volumenangaben (bzw. die hierzu identischen Flächenangaben) der verschiedenen Metalloxid-Phasen sind normiert und Relativangaben bezüglich des Gesamtvolumens (bzw. der Gesamtfläche), das von den materiellen Teilchen (Körnern) des Targetmaterials eingenommen wird. Das von den Poren des Targetmaterials eingenommene Volumen (bzw. die hierzu identische Fläche) ist von diesem Gesamtvolumen (bzw. dieser Gesamtfläche) ausgeklammert. Die Volumenangaben (bzw. die hierzu identischen Flächenangaben) der einzelnen Metalloxid-Phasen addieren sich daher allein ohne das Porenvolumen auf 100%.

In einer bevorzugten Ausführungsform liegt im Targetmaterial das atomare Verhältnis von O zu Mo in einem Bereich von 2,1 bis 2,48, weiter bevorzugt bei 2,1 bis 2,45, weiter bevorzugt 2,1 bis 2,42, und weiter bevorzugt 2,2 bis 2,4. Insbesondere bevorzugt ist im Targetmaterial das atomare Verhältnis von O zu Mo 2,375.

Gemäß der vorliegenden Erfindung liegt der Gesamtsauerstoffgehalt des Targetmaterials unter 71 at%. Vorzugsweise liegt der Gesamtsauerstoffgehalt im Bereich zwischen 67,7 At.% und 71 At.%.

Molybdän kann in unterschiedlichen Oxidationsstufen vorliegen, insbesondere in Form von MoO₂, von MoO₃, sowie in Form einer Mehrzahl von substöchiometrischen Oxiden MoO_{y}, wie z.B. Mo₄O₁₁ (y=2,75), Mo₁₇O₄₇ (y=2,76), Mo₅O₁₄ (y=2,8), Mo₈O₂₃ (y=2,875), Mo₉O₂₆ ((y=2,89) Hochtemperaturmodifikation) und Mo₁₈O₅₂ ((y=2,89) Niedertemperaturmodifikation).

Wie nachstehend in der Tabelle gezeigt weisen von einem MoO₂ Target abgeschiedene Schichtsysteme (Glassubstrat/MoOₓ (50 nm)/Aluminium (200 nm)) eine Reflektivität von 13,9% bei einer Wellenlänge von 550 nm auf, ein für die hier im Fokus stehenden Anwendungen (z.B. elektronische Anzeigen für Fernseher, Mobiltelefone, touch screen) zu hoher Reflexionswert. Der Schichtwiderstand einer solchen MoOₓ Einzelschicht beträgt 2200 µOhm · cm. Demgegenüber zeigt ein vergleichbares Schichtsystem mit einer MoOₓ-Schicht eines MoO_{2,75}-Sputtertargets eine Reflektivität von 5,5% bei einer Wellenlänge von 550 nm, der Schichtwiderstand einer Einzelschicht beträgt jedoch 43600 µOhm · cm. Überraschenderweise zeigt ein Schichtsystem mit einer MoOₓ-Schicht, abgeschieden von einem MoO_{2.375} Sputtertarget (erfindungsgemäß) eine sehr niedrige Reflektivität von 5,5% bei 550 nm und die Einzelschicht gleichzeitig einen niedrigen elektrischen Widerstand von 22500 µOhm · cm auf.

| MoOx-Schicht abgeschieden von einem Sputteringtarget mit einer Zusammensetzung von: | Spezifischer elektrischer Schichtwiderstand einer 50 nm dicken MoOx Einzelschicht | Reflektivität bei einer Wellenlänge von 550 nm von einer 50 nm dicken MoOx Schicht in Kombination mit einer 200 nm dicken Aluminium Deckschicht |
|---|---|---|
| MoO₂ | 2200 µOhm·cm | 13,9% |
| MoO_{2,375} | 22500 µOhm·cm | 5,5% |
| MoO_{2,75} | 43600 µOhm·cm | 5,5% |

Gemäß der vorliegenden Erfindung besteht das Targetmaterial aus einer MoO₂-Phase sowie mindestens einer substöchiometrischen Metalloxidphase, bei der mindestens ein Metall Molybdän ist, MoO₃, in einem Anteil, bezogen auf ein Schliffbild desselben- gemessen mit einem Raman-Mikroskop - von 0 Vol.% bis 2 Vol.%, optional einem Dotierungselement sowie unvermeidlichen Verunreinigungen. Wenn ein Dotierungselement enthalten ist, ist die MoO₂-Phase ist in einem Anteil von 22 bis 42 Vol.% im Targetmaterial, jeweils bezogen auf ein Schliffbild desselben - gemessen mit einem Raman-Mikroskop, enthalten.

Erfindungsgemäß liegt in dem Targetmaterial bezogen auf ein Schliffbild desselben - gemessen mit einem Raman-Mikroskop - der Anteil von MoO₃ im Bereich von 0 - 2 Vol.%, d.h. der Anteil ist ≤ 2 Vol.%. Der Anteil von MoO₃ sollte möglichst niedrig gehalten werden, da MoO₃ elektrisch isolierend ist (elektrische Leitfähigkeit kleiner als 1 x 10⁻⁵ S/m), was zu Partikelbildung beim Beschichtungsprozess führen kann. Zudem ist MoO₃ wasserlöslich, was nachteilig bei der mechanischen Bearbeitung sowie der Lagerung des Targets ist. Vorzugsweise ist MoO₃ in dem Targetmaterial mittels Raman-Spektroskopie überhaupt nicht nachweisbar (d.h. Anteil von 0 Vol.%), bzw. wird - wenn sie nicht ganz vermeidbar ist - auf einen Anteil im Bereich von 0,1 - 1,0 Vol.% gehalten.

Der vorliegenden Erfindung liegt die Erkenntnis zugrunde, dass es im Hinblick auf die Prozessstabilität des Sputterprozesses vorteilhaft ist, wenn der Sauerstoffgehalt des Targetmaterials identisch oder im Wesentlichen identisch zu demjenigen der herzustellenden Schicht ist. Vorzugsweise weichen der Sauerstoffgehalt (Gew.%) des Targetmaterials und der Sauerstoffgehalt (Gew.%) der herzustellenden Schicht um maximal ± 2 Gew.% voneinander ab. Eine Zuführung von Sauerstoff über das Prozessgas ist damit nicht oder nur zu einem geringen Anteil erforderlich, wodurch Hystereseeffekte unterdrückt und die Prozessführung vereinfacht werden.

Reine Molybdänoxid-Schichten haben attraktive elektro-optische Eigenschaften. Allerdings weisen sie eine schlechte Beständigkeit gegen alkalische Medien auf, beispielsweise gegenüber der starken Base Tetramethyl-AmmoniumHydroxid (TMAH). Es wurde jedoch überraschenderweise gefunden, dass aus dem erfindungsgemäßen Targetmaterial abgeschiedene Schichten niedrigere, also vorteilhaftere, Ätzraten gegenüber TMAH aufweisen als Schichten, die von Targetmaterialien mit substöchiometrischen MoOₓ - Zusammensetzungen mit einem x-Bereich von >2,5 bis 2,98 abgeschieden wurden.

Wenn kein Dotierungselement im Targetmaterial enthalten ist, liegt der Phasenanteil von Mo₄O₁₁ im Targetmaterial, bezogen auf ein Schliffbild desselben - gemessen mit einem Raman-Mikroskop - im Bereich von 22 bis 77 Vol.%, und der Phasenanteil von MoO₂ im Targetmaterial, bezogen auf ein Schliffbild desselben - gemessen mit einem Raman-Mikroskop - im Bereich von 23 bis 78 Vol.%, wobei der Gesamtsauerstoffgehalt ≤ 71,4 At.% beträgt.

Auch in der vorliegenden Erfindung kann die Zugabe von Dotierungselementen in die substöchiometrische molybdänoxidhaltige Schicht (und entsprechend in das Targetmaterial des Sputteringtargets), die Ätzrate in gängigen Nassätzmedien (z.B. PAN-Ätze auf der Basis von Phosphorsäure, Salpetersäure und Essigsäure zum Strukturieren von Aluminium-Metallisierungen, Ätze auf H₂O₂-Basis zum Strukturieren von Cu) weiter abgesenkt werden, ohne dass sich die elektro-optischen Eigenschaften erheblich ändern.

Das Dotierungselement Me wird erfindungsgemäß aus der aus der Gruppe bestehend aus Ti, Zr, Hf, V, Nb, Ta, Cr, und W ausgewählt.

In einer bevorzugten Ausführungsform enthält das Targetmaterial ein Dotierungselement Me aus der aus Tantal (Ta), Niob (Nb), Vanadium (V) und Titan (Ti) bestehenden Gruppe. Besonders bevorzugt ist dabei die aus Ta und Nb bestehende Gruppe, weiter bevorzugt ist Ta.

Erfindungsgemäß liegt in dem Targetmaterial der Anteil des Dotierungselements Me in At.% relativ zu dem Gesamtgehalt an Mo und dem Dotierungselement Me in At.% in Summe in dem Bereich von 0,02 - 0,15, vorzugsweise in einem Bereich von 0,05 bis 0,12.

In dieser Ausführungsform liegt im Targetmaterial neben einer MoO₂ Phase bevorzugt die Mischoxidphase (Mo₁₋ₓMeₓ)₅O₁₄ vor, mit einem Phasenanteil, bezogen auf ein Schliffbild desselben - gemessen mit einem Raman-Mikroskop - im Bereich von 50 bis 78 Vol.%. In dieser Ausführungsform ist Ta das bevorzugte Dotierungselement.

Weiterhin vorteilhaft ist, dass das erfindungsgemäße Sputteringtarget in industriellem Maßstab als kompaktes Bauteil (kompaktes Targetmaterial von z.B. mindestens 1 kg pro Targetsegment) mit hoher relativer Dichte und hoher Phasenreinheit innerhalb kurzer Prozesszeiten (z.B. Haltezeiten typischerweise < 12 Stunden) herstellbar ist, wie nachstehend noch im Detail beschrieben wird.

In dem Targetmaterial können herstellungsbedingte "Verunreinigungen" (Metalle wie auch Nichtmetalle) enthalten sein, wie z.B. Natrium (Na), Kalium (K), Antimon (Sb), Eisen (Fe), Kohlenstoff (C), Bor (B) und Stickstoff (N). Der Gesamtgehalt solcher Verunreinigungen ist typischerweise < 1000 µg/g.

Erfindungsgemäß liegt in dem Targetmaterial der Sauerstoff-Gehalt in Gew.% im Bereich von 25,9 bis 29,5 Gew.%. Der Sauerstoff-Gehalt in der abgeschiedenen Schicht beeinflusst die optische Reflexion, so dass vorzugsweise in dem Targetmaterial ein weitgehend entsprechender Sauerstoff-Gehalt, der typischerweise in dem oben genannten Bereich liegt, eingestellt wird. Weiterhin wird innerhalb dieses Bereiches eine ausreichende elektrische Leitfähigkeit erzielt, so dass ein DC (direct current; Gleichstrom) Sputterprozess ermöglicht wird (während elektrisch isolierende Targets mit einem RF (RF: radio frequency; d.h. Hochfrequenz) Sputterprozess (d.h. Wechselstrom) gesputtert werden müssen, was mit erhöhten Kosten (insbesondere bzgl. der Ausgestaltung der Sputteranlage) verbunden ist. Der Sauerstoff-Gehalt kann dabei - wie nachstehend noch ausführlicher beschrieben wird - im Rahmen der Herstellung durch Einwaage entsprechender oxidhaltiger Pulver eingestellt werden, so dass der eingewogene Sauerstoff-Anteil (im Verhältnis zu dem eingewogenen MetallAnteil) dem gewünschten Sauerstoff-Gehalt des Targetmaterials entspricht. Die Betrachtung lediglich des Gesamt-Sauerstoff-Gehalts in dem Targetmaterial ist zielführend, da sich die exakte Besetzung der verschiedenen Gitterplätze in den Metalloxidphasen gegebenenfalls auch temperaturabhängig ändern kann. Der Gesamt-Sauerstoff-Gehalt im Targetmaterial wird vorliegend mittels Trägergasheißextraktion (Nachweis des Sauerstoffes als CO bzw. CO₂ mittels Infrarotmesszelle, z.B. mit einem Gerät LECO RO300 oder LECO 836) ermittelt.

Am Targetmaterial selbst können die Anteile der enthaltenen Metalle sowie das Verhältnis Me/(Mo+Me) mittels chemischer Analyse, insbesondere mittels ICP-MS (Inductively Coupled Plasma Mass Spectroscopy; Massenspektrometrie mit induktiv gekoppeltem Plasma) oder mit ICP-OES (Inductively Coupled Plasma Optical Emission Spectrometry; Optische Emissionsspektrometrie mit induktiv gekoppeltem Plasma), bestimmt werden.

Gemäß einer Weiterbildung weist das Targetmaterial eine relative Dichte von ≥ 95% (d.h. in einem Bereich von 95 - 99,9%), insbesondere von ≥ 97% (d.h. in einem Bereich von 97 - 99,9%), vorzugsweise von ≥ 98% (d.h. in einem Bereich von 98 - 99,9%) auf. Die Dichte wird durch nachstehend genauer erläuterter Trockenpräparation von Proben des Targetmaterials ermittelt. Ein kompaktes Targetmaterial mit einer hohen relativen Dichte ist für die Qualität der abgeschiedenen Schichten wichtig, da weniger dichte Targetmaterialien beim Sputtern zu Blitzentladungen ("Arcs") und Partikelbildung führen können. Die Bestimmung der relativen Dichte erfolgt mittels digitaler Bildanalyse anhand von lichtmikroskopischen Bildaufnahmen des metallographischen Schliffs des Targetmaterials, bei dem der relative Flächenanteil "FA" der Poren (FA: Flächenanteil der Poren relativ zur untersuchten Gesamtfläche) ausgewertet wird. Die relative Dichte entspricht dann dem Wert (1-FA), wobei sie als arithmetisches Mittel aus drei derartigen Porositätsmessungen berechnet wird. Die Vorgehensweise ist nachstehend im Detail beschrieben.

Gemäß einer Weiterbildung weit das Targetmaterial eine elektrische Leitfähigkeit von ≥ 100 S/m bei 25°C auf. Hierdurch wird ein DC Sputtern ermöglicht und auch in der hergestellten Schicht wird eine ausreichende elektrische Leitfähigkeit erzielt. Die elektrische Leitfähigkeit wird dabei mit der 4-Punkt-Messmethode über einen Widerstands-Messstand (z.B. Ulvac ZEM3) gemessen.

Sputteringtarget gemäß einem der vorangehenden Ansprüche, dadurch gekennzeichnet, dass das Targetmaterial eine Temperaturleitfähigkeit von ≥ 2 mm²s⁻¹ bei 25°C aufweist. Die Temperaturleitfähigkeit kann mittels Laser Flash Analyse (LFA) bestimmt werden.

Sputteringtarget gemäß einem der vorangehenden Ansprüche, dadurch gekennzeichnet, dass das Targetmaterial eine Wärmeleitfähigkeit von ≥ 3,5 W/mK bei 25°C aufweist.

Gemäß einer Weiterbildung liegt das Targetmaterial als ein pulvermetallurgisch hergestellter (makroskopischer) Festkörper vor. Die pulvermetallurgische Herstellungsroute ermöglicht eine kostengünstige Herstellung des Targetmaterials in industriellem Maßstab als kompaktes Bauteil (kompaktes Targetmaterial von z.B. mindestens 1 kg pro Targetsegment) mit hoher relativer Dichte und hoher Phasenreinheit innerhalb kurzer Prozesszeiten (z.B. Haltezeiten typischerweise < 12 Stunden). Unter einer pulvermetallurgischen Herstellung wird dabei verstanden, dass entsprechende Ausgangspulver (die im Falle mehrerer Pulver vorher entsprechend gemischt werden) durch Anwendung von Druck und/oder Temperatur verdichtet werden. Die pulvermetallurgische Herstellung führt dabei zu einer charakteristischen Mikrostruktur des Targetmaterials, insbesondere zu einem mehrphasigen und feinkörnigen Gefüge. Die pulvermetallurgische Herstellung ist für einen Fachmann ohne weiteres an dem Targetmaterial anhand eines Schliffbildes im Lichtmikroskop, im Rasterelektronenmikroskop (REM) oder über Raman-Mikroskop erkennbar.

Als Ausgangspulver wird vorzugsweise eine Pulvermischung aus MoO₂, MoO₃, gegebenenfalls enthaltend geringe Anteile an substöchiometrischen Molybdänoxiden wie insbesondere Mo₄O₁₁, sowie aus einem oder mehreren Oxiden eines Dotierungselements Me gebildet. Die Anteile der verschiedenen Pulver werden so eingewogen, dass das gewünschte Mengenverhältnis der Elemente Mo, Me und O eingestellt wird. MoO₂ und MoO₃ sind leicht zugängliche, günstige und unter Umgebungsbedingungen thermodynamisch stabile, einfach zu handhabende Rohstoffe. Substöchiometrische Oxide können durch Reduktion von MoO₃-Pulver in einer entsprechenden Atmosphäre wie H₂ hergestellt werden.

Die Mischung der Pulver wird vorzugsweise in einem Intensivmischer oder auch mit einem Pflugscharmischer durchgeführt, wobei auf eine sehr gute Durchmischung der Pulver zu achten ist.

Das Verdichten kann insbesondere mittels Heißpressen, Heiß-isostatisch-Pressen, Spark Plasma Sintern (SPS) oder Pressen-Sintern erfolgen. Die Verdichtung erfolgt dabei insbesondere bei Temperaturen zwischen 600 und 800 °C und Pressdrücken zwischen 15 und 110 MPa. Vorzugsweise erfolgt die Verdichtung, insbesondere wenn erhöhte Temperaturen eingestellt werden, in Vakuum oder in Schutzgasatmosphäre (z.B. Argon). Bei SPS erfolgt die Verdichtung über Anwendung von Druck und Temperatur, wobei die Wärme intern durch einen durch die Pulvermischung geführten elektrischen Strom erzeugt wird. Beim Heißpressen erfolgt die Verdichtung ebenfalls über Anwendung von Druck und Temperatur, wobei die Wärme von außerhalb über eine beheizte Form zugeführt wird. Beim Heiß-isostatisch Pressen befindet sich das Ausgangspulver in einer abgeschlossenen Kapsel und die Verdichtung erfolgt unter Anwendung von Druck und Temperatur auf die Kapsel. Bei einer Verdichtung mittels Pressen-Sintern wird das Ausgangspulver zu einem Grünling gepresst und dieser anschließend durch Wärmebehandlung unterhalb der Schmelztemperatur gesintert.

Während des Verdichtungsprozesses werden die Ausgangspulver in einer Festphasenreaktion, bzw. je nach chemischer Zusammensetzung und Prozessbedingungen auch Flüssigphasenreaktionen, bzw. Mehrphasenreaktionen (z.B. fest-flüssig) in das Targetmaterial umgewandelt. Nach dem Verdichten kann eine mechanische Nachbearbeitung, beispielsweise durch spanabhebende Werkzeuge, zur gewünschten Endgeometrie bzw. zur Oberflächenaufbereitung (Einstellung einer gewünschten Rauigkeit der Oberfläche) erfolgen. Das erfindungsgemäße Targetmaterial zeigt aufgrund der erhöhten Biegebruchfestigkeit und höherer Wärmeleitfähigkeit eine verbesserte Bearbeitbarkeit, z.B. bei der Zerspanung (weniger Materialausbrüche) und beim Bonden (geringere Neigung der Rissbildung). Gegebenenfalls sind noch weitere Bauteile, wie z.B. Rückplatte(n), Trägerrohr(e), Anschlussstück(e), Einsätz(e) zur Vervollständigung des Sputteringtargets anzubringen.

Die vorliegende Erfindung betrifft ferner die Verwendung eines Sputteringtargets gemäß der vorliegenden Erfindung, das zusätzlich gemäß einer oder mehrerer der oberhalb beschriebenen Weiterbildungen und Varianten ausgebildet sein kann, zur Gasphasen-Abscheidung einer molybdänoxidhaltigen Schicht, wobei das Sputterverfahren als DC-Sputterverfahren bzw. gepulstes DC-Sputterverfahren in einer Edelgasatmosphäre ohne Sauerstoff oder alternativ unter Zufuhr von höchstens 20 Vol.% Sauerstoff als Reaktivgas erfolgt. Beim Gleichspannungssputtern, oder DC-Sputtern, wird zwischen dem als Kathode geschalteten Sputteringtarget und einer Anode (in der Regel das Gehäuse der Beschichtungsanlage und/oder Abschirmbleche in der Vakuumkammer) eine Gleichspannung angelegt. Das DC-Sputterverfahren bzw. gepulste DC-Sputterverfahren erfolgt dabei in einer Edelgasatmosphäre, insbesondere einer Argongasatmosphäre, bevorzugt nicht-reaktiv ohne zusätzliche Zufuhr von Sauerstoff. Die dabei abgeschiedenen Schichten haben gegebenenfalls aufgrund einer leichten Sauerstoff-Verarmung beim Beschichtungsprozess (Abtransport von gebildetem Sauerstoff über das abgesaugte Prozessgas) einen geringfügig niedrigeren Sauerstoff-Gehalt als das verwendete Targetmaterial, wobei dies je nach Beschichtungsanlage und Betriebsweise leicht variieren kann. Um molybdänoxidhaltige Schichten mit einem höheren Sauerstoffgehalt als dem des Targetmaterials herzustellen, kann das Targetmaterial auch reaktiv unter Zufuhr von höchstens 20 Vol.% Sauerstoff (bezogen auf die Zusammensetzung des Reaktivgases) gesputtert werden, vorzugsweise < 10 Vol.%, noch bevorzugter < 5 Vol.%, wobei durch den Einsatz eines oxidischen Targetmaterials die Menge an zugeführtem Sauerstoff vergleichsweise niedrig gehalten werden kann. Die Nachteile vom reaktiven Sputtern (Hystereseeffekte, potenzielle Inhomogenitäten der abgeschiedenen Schicht) wirken sich daher nicht so stark aus.

Hierin offenbart sind ferner molybdänoxidhaltige Schichten, die durch die oben genannte Verwendung abgeschieden werden. Die Vorteile dieser Schichten, wie niedrige Reflektivität, niedriger Schichtwiderstand, sind anhand der obigen Tabelle bereits diskutiert worden.

Weitere Vorteile und Zweckmäßigkeiten der Erfindung ergeben sich anhand der nachfolgenden Beschreibung von Ausführungsbeispielen unter Bezugnahme auf die beigefügten Figuren.

Von den Figuren zeigen:

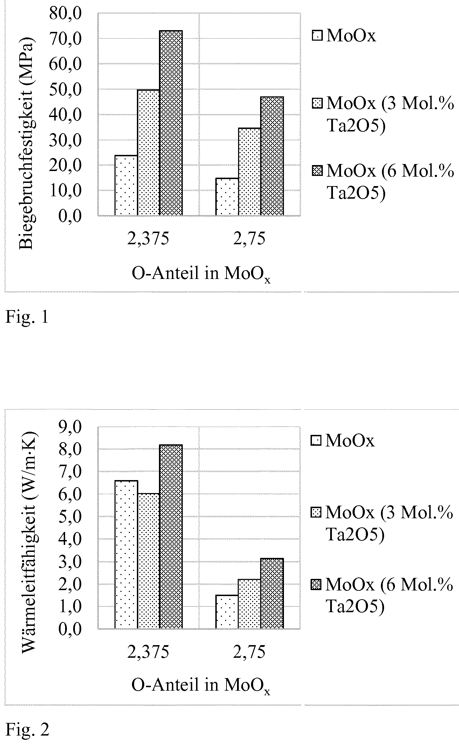

- Fig. 1:: ein Diagramm, in dem die Biegebruchfestigkeiten, ermittelt im 4-Punkt-Biegeversuch und angegeben in MPa (Megapascal), für ein erfindungsgemäßes Molybdän-Oxid (Beispiel 1) und zwei erfindungsgemäße Molybdän-Tantal-Oxid Sputteringtargets (Beispiel 2, Beispiel 3) und drei Vergleichsbeispiele (MoOx, O-Anteil x=2,75; 0, 3 und 6 Mol.% Ta₂O₅) aufgetragen sind;
- Fig. 2:: ein Diagramm, in dem die Wärmeleitfähigkeiten, angegeben in W/m·K (Watt pro Meter Kelvin), für ein erfindungsgemäßes Molybdän-Oxid (Beispiel 1) und zwei erfindungsgemäße Molybdän-Tantal-Oxid Sputteringtargets (Beispiel 2, Beispiel 3) und drei Vergleichsbeispiele (MoOx, O-Anteil x=2,75; 0, 3 und 6 Mol.% Ta₂O₅) aufgetragen sind;

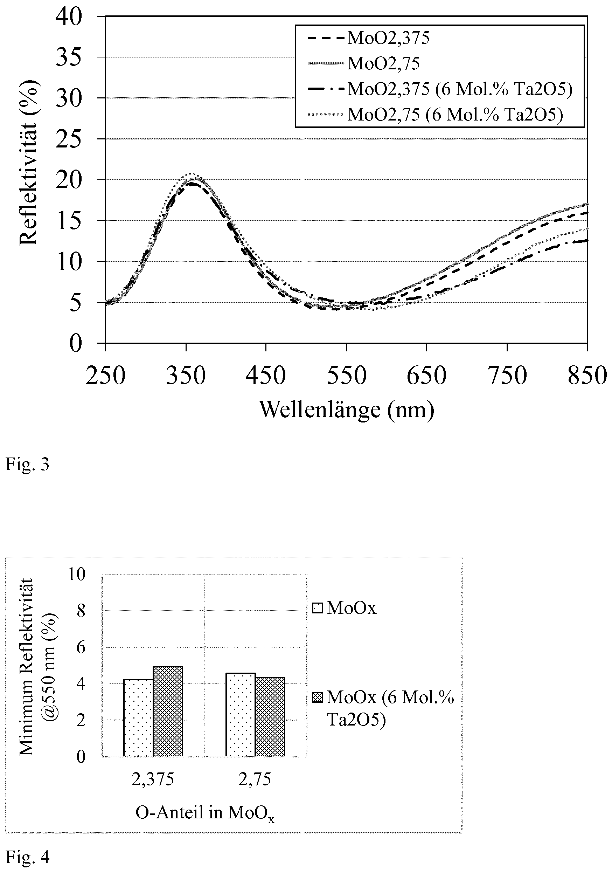

- Fig. 3:: ein Diagramm, in dem die Reflektivität in (%) über der Wellenlänge (nm) (Nanometer) aufgetragen ist, für Schichtsysteme, die in Sputterversuchen mit einem erfindungsgemäßen Molybdän-Oxid (Beispiel 1) und einem erfindungsgemäßen Molybdän-Tantal-Oxid Sputteringtarget (Beispiel 3) und zwei Vergleichsbeispiele (MoOx, O-Anteil x=2,75; 0 und 6 Mol.% Ta₂O₅) abgeschieden wurden;
- Fig. 4:: ein Diagramm, in dem die minimale Reflektivität in (%) bei einer Wellenlänge von 550 nm (@550 nm; Nanometer) aufgetragen ist, für Schichtsysteme, die in Sputterversuchen mit einem erfindungsgemäßen Molybdän-Oxid (Beispiel 1) und einem erfindungsgemäßen Molybdän-Tantal Oxid Sputteringtarget (Beispiel 3) und zwei Vergleichsbeispielen (MoOx, O-Anteil x=2,75; 0 und 6 Mol.% Ta₂O₅) abgeschieden wurden;

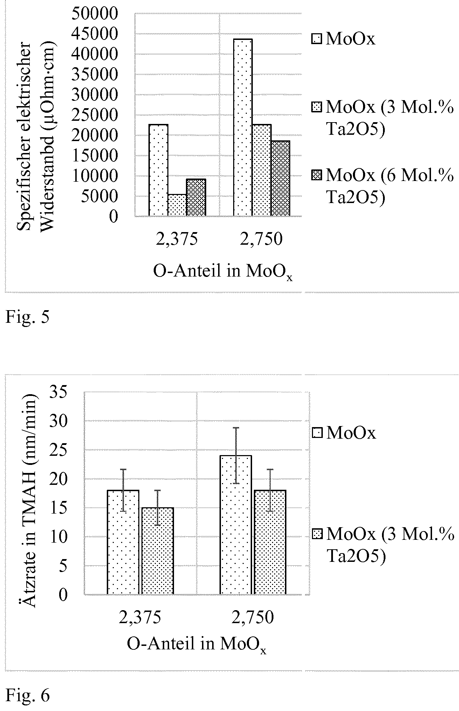

- Fig. 5:: ein Diagramm, in dem der spezifische elektrische Widerstand, ermittelt mit 4-Punkt-Messung und angegeben in µOhm·cm (Mikro-Ohm Zentimeter), aufgetragen ist, für Schichten, die in Sputterversuchen mit einem erfindungsgemäßen Molybdän-Oxid (Beispiel 1) und zwei erfindungsgemäßen Molybdän-Tantal-Oxid Sputteringtargets (Beispiel 2, Beispiel 3) und drei Vergleichsbeispielen (MoOx, O-Anteil x=2,75; 0, 3 und 6 Mol.% Ta₂O₅) abgeschieden wurden;
- Fig. 6:: ein Diagramm, in dem die Ätzrate, ermittelt in 2,36%iger wässriger TMAH-Lösung (Tetramethylammoniumhydroxid) und angegeben in nm/min (Nanometer pro Minute), aufgetragen ist, für Schichten, die in Sputterversuchen mit einem erfindungsgemäßen Molybdän-Oxid (Beispiel 1) und einem erfindungsgemäßen Molybdän-Tantal-Oxid Sputteringtarget (Beispiel 2) und zwei Vergleichsbeispielen (MoOx, O-Anteil x=2,75; 0 und 3 Mol.% Ta₂O₅) abgeschieden wurden;

### Herstellungsbeispiele:

### Beispiel 1: MoO_{2,375}

MoO₂-Pulver (Plansee SE) wird in einem Sieb mit Maschenweite 63 µm abgesiebt. 62 Mol.% des so erhaltenen MoO₂-Pulvers werden mit 38 Mol.% MoO₃-Pulver (Molymet) in einem Intensivmischer (Eirich) für 20 min. gemischt, so dass sich eine homogene Verteilung zwischen den Pulverkomponenten ergibt. Die erhaltende Pulvermischung wird in eine Graphitform mit den Abmessungen Ø250 mm und einer Höhe von 50 mm gegeben und in einer Heißpresse unter Vakuum bei einem Pressdruck von 25 MPa, einer Temperatur von 800 °C und einer Haltezeit von 120 min. verdichtet. Das kompaktierte Bauteil weist eine relative Dichte von 98,1% auf. Der überwiegende Anteil des erhaltenen Targetmaterials besteht aus der Mo₄O₁₁-Phase mit einem Anteil von 95,2 Vol.%. Das Targetmaterial weist zusätzlich eine MoO₂-Phase mit einem Anteil von 4,8 Vol.% auf.

### Beispiel 2: MoO_{2,375} + 3 Mol.% Ta₂O₅

MoO₂-Pulver (Plansee SE) wird in einem Sieb mit Maschenweite 63 µm abgesiebt. 76 Mol.% des so erhaltenen MoO₂-Pulvers werden mit 21 Mol.% MoO₃-Pulver (Molymet) und 3 Mol.% Tantalpentoxidpulver (H.C. Starck, Ta₂O₅) in einem Intensivmischer (Eirich) für 20 min. gemischt, so dass sich eine homogene Verteilung zwischen den Pulverkomponenten ergibt. Die erhaltende Pulvermischung wird in eine Graphitform mit den Abmessungen 0250 mm und einer Höhe von 50 mm gegeben und in einer Heißpresse unter Vakuum bei einem Pressdruck von 25 MPa, einer Temperatur von 800 °C und einer Haltezeit von 120 min. verdichtet. Das kompaktierte Bauteil weist eine relative Dichte von 98,1% auf. Der überwiegende Anteil des erhaltenen Targetmaterials besteht aus der (Mo_{0.93}Ta_{0.07})₅O₁₄-Phase mit einem Anteil von 69 Vol.%. Das Targetmaterial weist zusätzlich eine MoO₂-Phase mit einem Anteil von 29 Vol.% und eine Mo₄O₁₁-Phase mit einem Anteil von 2 Vol.% auf.

### Beispiel 3: MoO_{2,375} + 6 Mol.% Ta₂O₅

MoO₂-Pulver (Plansee SE) wird in einem Sieb mit Maschenweite 63 µm abgesiebt. 88 Mol.% des so erhaltenen MoO₂-Pulvers werden mit 8 Mol.% MoO₃-Pulver (Molymet) und 6 Mol.% Tantalpentoxidpulver (H.C. Starck, Ta₂O₅) in einem Intensivmischer (Eirich) für 20 min. gemischt, so dass sich eine homogene Verteilung zwischen den Pulverkomponenten ergibt. Die erhaltende Pulvermischung wird in eine Graphitform mit den Abmessungen 0250 mm und einer Höhe von 50 mm gegeben und in einer Heißpresse unter Vakuum bei einem Pressdruck von 25 MPa, einer Temperatur von 800 °C und einer Haltezeit von 120 min. verdichtet. Das kompaktierte Bauteil weist eine relative Dichte von 99,7% auf. Der überwiegende Anteil des erhaltenen Targetmaterials besteht aus der (Mo_{0.93}Ta_{0.07})₅O₁₄-Phase mit einem Anteil von 57 Vol.%. Das Targetmaterial weist zusätzlich eine MoO₂-Phase mit einem Anteil von 41 Vol.% und eine Ta₂O₅-Phase mit einem Anteil von 2 Vol.% auf.

### Physikalische und mechanische Kenndaten:

Im Rahmen einer Versuchsserie wurden die nach Beispiel 1 bis Beispiel 3 hergestellten Molybdän-Tantal-Oxid-Sputteringtargets (MoOx, O-Anteil x=2,375) im Vergleich mit nicht-erfindungsgemäßen Molybdän-Tantal-Oxid-Sputteringtargets (MoOx, O-Anteil x=2,75) untersucht. Der Gehalt an Ta₂O₅ in der zur Herstellung der Sputteringtargets eingesetzten Pulvermischung betrug dabei variierend 0, 3 bzw. 6 Mol.%.

In Figur 1 sind die Biegebruchfestigkeiten (ermittelt im 4-Punkt-Biegeversuch) für verschiedene Molybdän-Oxid und Molybdän-Tantal-Oxid Sputteringtargets dargestellt. Die nach den Beispielen 1 bis 3 hergestellten Sputteringtargets (MoOx, O-Anteil x=2,375) weisen im Vergleich zu nicht-erfindungsgemäßen Sputteringtargets (MoOx, O-Anteil x=2,75) für alle untersuchten Zusammensetzungen jeweils höhere Biegebruchfestigkeiten auf.

In Figur 2 sind die Wärmeleitfähigkeiten (ermittelt mittels Laser Flash Analyse) für verschiedene Molybdän-Oxid und Molybdän-Tantal-Oxid Sputteringtargets dargestellt. Die nach den Beispielen 1 bis 3 hergestellten Sputteringtargets (MoOx, O-Anteil x=2,375) weisen im Vergleich zu nicht-erfindungsgemäßen Sputteringtargets (MoOx, O-Anteil x=2,75) für alle untersuchten Zusammensetzungen jeweils höhere Wärmeleitfähigkeiten auf.

### Sputterversuche:

Im Rahmen einer Versuchsserie wurden die nach Beispiel 1 bis Beispiel 3 hergestellten Molybdän-Oxid und Molybdän-Tantal-Oxid-Targetmaterialien (MoOx, O-Anteil x=2,375) im Vergleich zu nicht-erfindungsgemäßen Molybdän-Tantal-Oxid-Sputteringtargets (MoOx, O-Anteil x=2,75) bei vorgegebenen Prozessbedingungen nicht-reaktiv gesputtert, um die Schichteigenschaften zu ermitteln. Es wurde dabei eine Sputterleistung von 200 W und ein Prozessdruck des Argons von 5,0 x 10-3 mbar (22 sccm; sccm: Standardkubikzentimeter pro Minute) verwendet.

Die Reflektivität der erzeugten Schichten wurde als ein Kriterium für die Beurteilung verwendet. Zur Bestimmung der Reflektivität wurden Glassubstrate (Corning Eagle XG, 50 x 50 x 0,7 mm³) mit Molybdän-Oxid bzw. Molybdän-Tantal-Oxid und einer Deckschicht aus 200 nm Al (Aluminium) beschichtet. Die Reflektion wurde durch das Glassubstrat hindurch unter Verwendung eines Perkin Elmer Lambda 950 Fotospektrometers über den angegebenen Wellenbereich hinweg gemessen. Um eine möglichst geringe Reflektivität zu erhalten, wurde die Schichtdicke des Molybdän-Oxids bzw. Molybdän-Tantal-Oxids in einem Bereich von 40 bis 60 nm variiert. Die Ergebnisse aus dieser Versuchsserie sind in Fig. 3 und Fig. 4 dargestellt. In Fig. 3 ist jeweils die Reflektivität in (%) über der Wellenlänge in (nm; Nanometer) aufgetragen. Dabei liegen die Reflektivitätskurven aus Beispiel 1 und Beispiel 3, die als mit schwarzer Farbe gezeichneten Kurven, mit gestrichelten Linien für Beispiel 1 und mit gestricheltengepunkteten Linien für Beispiel 3, eingezeichnet sind, in einem vergleichbaren (fast deckungsgleichen) Bereich wie die Reflektivitätskurven der nicht-erfindungsgemäßen Referenzschichtsysteme (eingetragen mit grau gezeichneten Kurven als durchgezogene bzw. gepunktete Linien). Die Minima der gemessenen Reflektivitätskurven liegen für Schichten aus Beispiel 1 und Beispiel 3 bei nahezu gleichen Werten wie die Minima der Reflektivitätskurven der nicht erfindungsgemäßen Referenzen (MoOx, O-Anteil x=2,75).

In Fig. 4 sind jeweils die Werte der absolut geringsten gemessenen Reflektivitäten in (%) bei einer Wellenlänge von 550 nm in Abhängigkeit der jeweils verwendeten Molybdän-Oxid bzw. Molybdän-Tantal-Oxid Sputteringtargets aufgetragen ist. Zur Auswertung kamen dabei alle Reflektivitätskurven, die an den gesputterten Molybdän-Oxid und Molybdän-Tantal-Oxidschichten mit Schichtstärken zwischen 40 und 60 nm bestimmt wurden. Wie aus einem Vergleich in Fig. 4 ersichtlich ist, wird bei den erfindungsgemäßen Sputteringtargets nach Beispiel 1 und 3 eine minimale Reflektivität erzielt, die vergleichbar ist mit der minimalen Reflektivität bei den nicht-erfindungsgemäßen Sputteringtargets (MoOx, O-Anteil x=2,75; 0 und 6 Mol.% Ta2O5).

An gesputterten Molybdän-Oxid und Molybdän-Tantal-Oxid Schichten mit einer Dicke von 50 nm, die mit den Sputteringtargets aus Beispiel 1 bis 3 (MoOx, x=2,375) abgeschieden wurden, wurde außerdem der spezifische elektrische Widerstand (4-Punkt-Messung, Keithley 2400 Source Meter) bestimmt und mit Schichten verglichen, die mit nicht-erfindungsgemäßen Sputteringtargets (MoOx, x=2,75) gesputtert wurden. Wie aus einem Vergleich in Fig. 5 ersichtlich ist, wird mit den erfindungsgemäßen Sputteringtargets nach Beispiel 1 bis 3 ein niedrigerer spezifischer elektrischer Widerstand der Schichten erzielt wie bei den nicht-erfindungsgemäßen Sputteringtargets.

An gesputterten Molybdän-Oxid und Molybdän-Tantal-Oxid Schichten mit einer Dicke von 100 nm, die mit den Sputteringtargets (MoOx, O-Anteil x=2,375) aus Beispiel 1 und 2 abgeschieden wurden, wurde außerdem die Nassätzrate in 2,36%iger wässriger TMAH-Lösung (Tetramethylammoniumhydroxid) bestimmt und mit der Ätzrate von Schichten verglichen, die mit nicht-erfindungsgemäßen Sputteringtargets (MoOx, O-Anteil x=2,75) gesputtert wurden. Wie aus einem Vergleich in Fig. 6 ersichtlich ist, wird mit den erfindungsgemäßen Sputteringtargets nach Beispiel 1 und 2 eine niedrigere Ätzrate erzielt wie mit dem nicht-erfindungsgemäßen Sputteringtargets.

Ferner weisen die erfindungsgemäßen Sputteringtargets die oberhalb erläuterten weiteren Vorteile auf. Insbesondere zeigen sie aufgrund ihrer erhöhten Wärmeleitfähigkeit und erhöhten Biegebruchfestigkeit eine verringerte Rissneigung beim Bonden bzw. zeigt sich beim Sputtern der erfindungsgemäßen Targetmaterialien ein günstigeres Sputterverhalten (gleichmäßige Sputterrate unter Vermeidung von Lichtbögen (Arcs) und geringe Partikelbildung), was sich positiv auf die Schichtqualität auswirkt (homogene Schichtzusammensetzung; gleichmäßige Schichtdicke; wenig Schichtfehler). Gesputterte Schichten, die mit den erfindungsgemäßen Sputteringtargets abgeschieden wurden, weisen einen niedrigen spezifischen elektrischen Widerstand und niedrige Nassätzraten auf, was in Kombination mit Aluminium oder Kupfer-Schichten vorteilhaft ist.

### Probenpräparation:

Zur Bestimmung der Volumenanteile der in dem Targetmaterial enthaltenen Phasen und der Dichte des Targetmaterials wurde mittels Trockenpräparation ein metallographischer Schliff aus einem repräsentativen Probenteil hergestellt, indem eine Probe mit einer Fläche von ca. 10-15 x 10-15 mm² im Trockenschnittverfahren (Diamantdrahtsäge, Bandsäge, etc.) zugeschnitten, mittels Druckluft gereinigt, anschließend warm und leitend (C-dotiert) in Phenolharz eingebettet, geschliffen und poliert wurde. Da der gegebenenfalls vorhandene MoO₃-Phasenanteil wasserlöslich ist, ist eine Trockenpräparation wichtig. Der so erhaltene Schliff wurde anschließend lichtmikroskopisch analysiert.

### Bestimmung der Phasenanteile mittels Raman- Spektroskopie:

Zur ortsaufgelösten Bestimmung der in dem Targetmaterial enthaltenen Phasen wurde ein Raman-Mikroskop (Horiba LabRAM HR800) verwendet, bei dem ein konfokales Lichtmikroskop (Olympus BX41) mit einem Raman-Spektrometer gekoppelt ist. Die zu analysierende Oberfläche wurde dabei auf einer Fläche von 1 x 1 mm² mit Hilfe eines fokussierten Laserstrahls (He-Ne-Laser, Wellenlänge λ = 632,81 nm, 15 mW Gesamtleistung) Punkt für Punkt mit einer Schrittweite von 5 µm abgerastert (die zu untersuchende Probeoberfläche wurde auf einen motorisierten XYZ-Tisch fixiert und dieser bewegt). Für jeden einzelnen der 201 x 201 Messpunkte wurde ein vollständiges Raman- Spektrum erstellt ("Raman-Mapping"). Raman Spektren werden aus der rückgestreuten Strahlung gewonnen, die über ein optisches Gitter (300 Linien/mm; spektrale Auflösung: 2,6 cm⁻¹) wellenlängendispersiv aufgespalten, und mittels eines CCD-Detektors (1024 × 256 pixel multichannel CCD; Spektralumfang: 200-1050 nm) aufgenommen werden. Bei einem Mikroskop-Objektiv mit 100-facher Vergrößerung und numerischer Apertur NA von 0,9, welches zur Fokussierung des Laserstrahls aus dem Raman-Spektrometer dient, ließ sich eine theoretische Messpunkt-Größe von 0,7 µm² erzielen. Die Anregungsenergiedichte (5 mW/µm²) wird gering genug gewählt, um Phasenumwandlungen in der Probe zu vermeiden. Die Eindringtiefe der Anregungsstrahlung ist bei Molybdänoxiden auf einige Mikrometer begrenzt (im Falle von reinem MoO₃ z.B. auf ca. 4 µm). Pro Messpunkt wurde das Ramansignal über 1 s (s: Sekunde) Akquisitionszeit zeitlich gemittelt, wobei sich ein ausreichend gutes Signal-zu-Rauschverhältnis ergab. Durch automatisierte Auswertung dieser Raman-Spektren (Auswertesoftware Horiba LabSpec 6) wurde eine zweidimensionale Darstellung der Oberflächenzusammensetzung der Probe erstellt, aus der sich quantitativ die Domänengröße, Flächenanteile, etc. der verschiedenen Phasen ermitteln lassen. Zur genauen Identifizierung einer Molybdänoxidphase werden Referenzspektren an zuvor synthetisierten Referenzproben bzw. Referenzspektren an größeren homogenen Probenbereichen aufgenommen, wobei darauf geachtet wird, dass ein Referenzspektrum genau einer Metalloxid-Phase entspricht. In den Fig. 1 bis 6 sind verwendete Referenzspektren von (Mo_{0.93}Ta_{0.07})₅O₁₄ (Fig. 1), Ta₂O₅ (Fig. 2), Mo₁₈O₅₂ (Fig. 3), MoO₂ (Fig. 4), MoO₃ (Fig. 5), Mo₄O₁₁ (Fig. 6) dargestellt (in den einzelnen Spektren ist die Intensität (Anzahl) des gestreuten Lichts über der Raman-Verschiebung (cm⁻¹) aufgetragen). Die Analyse und Zuordnung der Raman-Spektren erfolgt dabei mit Hilfe des "Multivariante Analysis Modules" der oben genannten Auswertesoftware mittels der CLS-Methode (classical least square fitting). Das Probenspektrum S wird dazu als Linearkombination der einzelnen normalisierten Referenzspektren *Rᵢ* dargestellt, wobei *cᵢ* der jeweilige Gewichtungsfaktor und Δ ein Offsetwert ist, S= Σcᵢ Rᵢ + Δ. Jedem Messpunkt wird anschließend eine Farbe zugeordnet, die einer Metalloxid-Phase entspricht, wobei jeweils nur die Phase mit dem höchsten Gewichtungsfaktor *cᵢ* für die Farbzuordnung verwendet wird. Die Größe (des Betrages) des Gewichtungsfaktors *cᵢ* bestimmt die Helligkeit des Messpunkts. Dieses Vorgehen ist insofern gerechtfertigt, da sich in der Regel das Spektrum von einem Messpunkt eindeutig einer einzigen Metalloxid-Phase zuordnen lässt.

Bei dem verwendeten Objektiv wurde von allen 201 x 201 Messpunkten ein Probenspektrum erhalten, auch wenn auf einer Pore gemessen wurde. In diesem Fall stammte das Signal aus einem unter der Pore liegenden, tieferen Bereich. Falls für einzelne Messpunkte kein Raman-Spektrum erhalten wird, z.B. aufgrund einer Pore, so kann dieses aus der Bestimmung der Flächenanteile ausgenommen werden, d.h. das von den Poren des Targetmaterials eingenommene Volumen ist vom Gesamtvolumen ausgeklammert. Die Volumenangaben der einzelnen Molybdänoxid-Phasen addieren sich daher allein ohne das Porenvolumen auf 100%.

Die hier beschriebene Analysenmethode eignet sich sehr gut zur Bestimmung der relativen Phasenanteile der vorliegend in Frage kommenden Phasen.

### Bestimmung der relativen Dichte:

Die Bestimmung der relativen Dichte des Targetmaterials erfolgt mittels digitaler Bildanalyse von lichtmikroskopischen Bildaufnahmen des metallographischen Schliffs, bei dem der relative Flächenanteil "FA" der Poren ermittelt wird. Dazu erfolgte nach Präparation der Proben eine Bildaufnahme von je drei Hellfeld-Aufnahmen mit einer Größe von 1 x 1mm mit 100-facher Vergrößerung, wobei Zonen offensichtlicher Ausbrüche oder sonstiger Schadensbilder wie Kratzer aufgrund von Trockenpräparation nach Möglichkeit vermieden wurden. Die erhaltenen Bilder wurden mittels der in der IMAGIC-Bilddatenbank implementierten digitalen Bildverarbeitungssoftware ausgewertet. Dazu wurde am Bild abhängig von der Graustufe der Porenanteil (dunkel) anhand eines Histogramms markiert. Die Untergrenze des Intervalls wurde bei 0 (= schwarz) angesetzt. Demgegenüber muss die Obergrenze subjektiv anhand des Graustufen-Intensitätshistogramms eingeschätzt werden (255 = weiß). Der zu messende Bildbereich wurde eingestellt (ROI), um den Maßstabsbalken auszuschließen. Als Ergebnis erhält man den relativen Flächenanteil "FA" der Poren (in Prozent) und das entsprechend des selektierten Graustufenintervalls eingefärbte Bild (gefärbt bedeutet, dass dieser Pixel in die Messung aufgenommen wurde und demnach als Pore gezählt wurde). Der Wert (1-FA) für die relative Dichte wurde als arithmetisches Mittel aus drei derartigen Porositätsmessungen ermittelt.

## Patentansprüche

1. Sputteringtarget umfassend ein elektrisch leitfähiges, oxidisches Molybdän-basiertes Targetmaterial, **dadurch gekennzeichnet, dass**
das Targetmaterial aus einer MoO₂-Phase sowie mindestens einer substöchiometrischen Metalloxidphase, bei der mindestens ein Metall Molybdän ist, MoO₃, in einem Anteil, bezogen auf ein Schliffbild desselben- gemessen mit einem Raman-Mikroskop wie in der Beschreibung angegeben- von 0 Vol.% bis 2 Vol.%, sowie optional Verunreinigungen besteht, wobei im Targetmaterial das atomare Verhältnis von Sauerstoff zu Molybdän in einem Bereich von 2,1 bis 2,5 liegt, mit der Maßgabe, dass der Gesamtsauerstoffgehalt des Targetmaterials unter 71 At.% sowie im Bereich von 25,9 bis 29,5 Gew.%, ermittelt durch Trägergasheißextraktion, liegt, wobei
das Targetmaterial ein Dotierungselement Me aus der aus Ti, Zr, Hf, V, Nb, Ta, Cr, und W bestehenden Gruppe in einem Anteil des Dotierungselements Me in At.% relativ zu dem Gesamtgehalt an Mo und dem Dotierungselement Me in At.% in Summe im Bereich von 0,02 - 0,15 enthält, die MoO₂-Phase in einem Anteil von 22 bis 42 Vol.% im Targetmaterial, jeweils bezogen auf ein Schliffbild desselben - gemessen mit einem Raman-Mikroskop wie in der Beschreibung angegeben, enthalten ist und eine Mischoxidphase (Mo₁₋ₓMeₓ)₅O₁₄, mit einem Phasenanteil, bezogen auf ein Schliffbild desselben - gemessen mit einem Raman-Mikroskop wie in der Beschreibung angegeben - im Bereich von 50 bis 78 Vol.% vorliegt.

2. Sputteringtarget gemäß Anspruch 1, **dadurch gekennzeichnet, dass** das Targetmaterial eine relative Dichte von ≥ 95%, vorzugsweise ≥ 98% bis 99,5% aufweist.

3. Sputteringtarget gemäß Anspruch 1 oder 2, **dadurch gekennzeichnet, dass** das Targetmaterial eine elektrische Leitfähigkeit von ≥ 100 S/m bei 25°C aufweist.

4. Sputteringtarget gemäß einem der vorangehenden Ansprüche, **dadurch gekennzeichnet, dass** das Targetmaterial eine Temperaturleitfähigkeit von ≥ 2 mm²s⁻¹ bei 25°C aufweist.

5. Sputteringtarget gemäß einem der vorangehenden Ansprüche, **dadurch gekennzeichnet, dass** das Targetmaterial eine Wärmeleitfähigkeit von ≥ 3,5 W/mK bei 25°C aufweist.

6. Sputteringtarget gemäß einem der vorangehenden Ansprüche, **dadurch gekennzeichnet, dass** das Targetmaterial als ein pulvermetallurgisch hergestellter Festkörper vorliegt.

7. Verwendung eines Sputteringtargets nach einem der Ansprüche 1 bis 6 zur Gasphasen-Abscheidung einer molybdänoxidhaltigen Schicht, **dadurch gekennzeichnet, dass** das Sputterverfahren als DC-Sputterverfahren bzw. gepulstes DC-Sputterverfahren in einer Edelgasatmosphäre ohne Sauerstoff oder alternativ unter Zufuhr von höchstens 20 Vol.% Sauerstoff als Reaktivgas erfolgt.

## Claims

1. Sputtering target comprising an electrically conductive oxidic molybdenum-based target material, **characterized in that**
the target material comprises an MoO₂ phase, and also at least one substoichiometric metal oxide phase in which at least one metal is molybdenum, MoO₃, in a proportion, based on a polished section thereof - measured with a Raman microscope as given in the description - of 0 Vol.% to 2 Vol.%, as well as optional impurities, where the atomic ratio of oxygen to molybdenum in the target material is in the range 2.1 to 2.5, with the proviso that the total oxygen content of the target material is below 71 at.% and is in the range of 25.9 to 29.5% by weight, determined by hot gas extraction, wherein
the target material comprises a doping element Me from the group consisting of Ti, Zr, Hf, V, Nb, Ta, Cr, and W, the total proportion of the doping element Me in at.% in the target material, relative to the total content Mo and of the doping element Me in at.%, is in the range 0.02 to 0.15, the proportion present of the MoO₂ phase in the target material, based on a polished section thereof - measured with a Raman microscope as given in the description is 22 to 42% by volume and a proportion of the mixed oxide phase (Mo₁₋ₓMeₓ)₅O₁₄ that, based on a polished section of the said material - measured with a Raman microscopy as given in the description - is in the range 50 to 78% by volume.

2. Sputtering target according to claim 1, **characterized in that** the relative density of the target material is ≥ 95%, preferably ≥ 98% to 99.5%.

3. Sputtering target according to claim 1 or 2, **characterized in that** the electrical conductivity of the target material is ≥ 100 S/m at 25°C.

4. Sputtering target according to any of the preceding claims, **characterized in that** the thermal diffusivity of the target material is ≥ 2 mm²s⁻¹ at 25°C.

5. Sputtering target according to any of the preceding claims, **characterized in that** the thermal conductivity of the target material is ≥ 3.5 W/mK at 25°C.

6. Sputtering target according to any of the preceding claims, **characterized in that** the target material is a solid produced by powder metallurgy.

7. Use of a sputtering target according to any of Claims 1 to 6 for the gasphase deposition of a molybdenum-oxide-containing layer, **characterized in that** the sputtering process is a DC sputtering process or, respectively, pulsed DC sputtering process in a noble-gas atmosphere in the absence of oxygen, or alternatively introduces at most 20% by volume of oxygen as reactive gas.

## Revendications

1. Cible de pulvérisation, comprenant un matériau cible électriquement conducteur, à base d'oxyde de molybdène, **caractérisée en ce que**
le matériau cible est constitué par une phase de MoO₂ ainsi que par au moins une phase d'oxyde métallique sous-stoechiométrique, dans laquelle au moins un métal est du molybdène, MoO₃, en une proportion, par rapport à une micrographie dudit matériau cible - mesurée à l'aide d'un microscope Raman comme indiqué dans la description - de 0% en volume à 2% en volume, ainsi que par d'éventuelles impuretés,
le rapport atomique d'oxygène à molybdène dans le matériau cible se situant dans une plage de 2,1 à 2,5 sous réserve que la teneur totale en oxygène du matériau cible est inférieure à 71% en atome et se situe dans la plage de 25,9 à 29,5% en poids, déterminée par extraction à chaud par un gaz porteur,
dans laquelle
le matériau cible contient un élément de dopage Me du groupe constitué par Ti, Zr, Hf, V, Nb, Ta, Cr et W en une proportion de l'élément de dopage Me en % en atome par rapport à la somme de la teneur totale en Mo et en élément de dopage Me en % en atome dans la plage de 0,02 - 0,15, la phase MoO₂ est contenue en une proportion de 22 à 42% en volume dans le matériau cible, à chaque fois par rapport à une micrographie dudit matériau cible - mesurée à l'aide d'un microscope Raman comme indiqué dans la description - et une phase d'oxyde mixte (Mo₁₋ₓMeₓ)₅O₁₄ se trouve en une proportion de phase, par rapport à une micrographie dudit matériau cible - mesurée à l'aide d'un microscope Ramon comme indiqué dans la description - dans la plage de 50 à 78% en volume.

2. Cible de pulvérisation selon la revendication 1, **caractérisée en ce que** le matériau cible présente une densité relative ≥ 95%, de préférence ≥ 98% à 99,5%.

3. Cible de pulvérisation selon la revendication 1 ou 2, **caractérisée en ce que** le matériau cible présente une conductivité électrique ≥ 100 S/m à 25°C.

4. Cible de pulvérisation selon l'une des revendications précédentes, **caractérisée en ce que** le matériau cible présente une conductivité de la température ≥ 2 mm²s⁻¹ à 25°C.

5. Cible de pulvérisation selon l'une des revendications précédentes, **caractérisée en ce que** le matériau cible présente une conductivité thermique ≥ 3,5 W/mK à 25°C.

6. Cible de pulvérisation selon l'une des revendications précédentes, **caractérisée en ce que** le matériau cible se trouve sous forme d'un corps solide fabriqué par métallurgie des poudres.

7. Utilisation d'une cible de pulvérisation selon l'une des revendications 1 à 6 pour le dépôt en phase gazeuse d'une couche contenant de l'oxyde de molybdène, **caractérisée en ce que** le procédé de pulvérisation a lieu sous forme d'un procédé de pulvérisation à courant continu ou, selon le cas, d'un procédé de pulvérisation à courant continu pulsé dans une atmosphère de gaz noble sans oxygène ou, en variante, avec introduction d'au plus 20% en volume d'oxygène en tant que gaz réactif.
